# EUROPEAN PATENT APPLICATION

(11) **EP 3 355 375 A1**
(43) Date of publication of application: **01.08.2018**
(21) Application number: 17766906.6
(22) Date of filing: 22.02.2017
(51) Int. Cl.: H01L 51/42, H01L 31/0256

(54) **SOLAR CELL AND MANUFACTURING METHOD THEREFOR**

(30) Priority: 16.03.2016 KR 20160031485
(71) Applicant: LG Chem, Ltd., Seoul 07336 (KR); Research & Business Foundation SungKyunKwan University, Gyeonggi-do 16419 (KR)
(72) Inventor: PARK, Eun Seok, Daejeon 34122 (KR); PARK, Nam-Gyu, Seoul 06219 (KR); SON, Dae-Yong, Suwon-si Gyeonggi-do 16421 (KR)
(74) Representative: Hoffmann Eitle
(86) International application number: PCT/KR2017/001951
(87) International publication number: WO 2017/160005

(57) **Abstract**

The present invention relates to a solar cell and a manufacturing method therefor. According to the manufacturing method, a highly efficient perovskite solar cell can be manufactured by inducing a spontaneous formation of a recombination preventing layer using the organic halide and the metal halide at a specific molar ratio.

## Description

### [TECHNICAL FIELD]

### CROSS-REFERENCE TO RELATED APPLICATION(S)

This application claims the benefit of priority from Korean Patent Application No. 10-2016-0031485 filed on March 16, 2016, the full disclosure of which is incorporated herein by reference.

The present invention relates to a solar cell and a method for manufacturing the same.

### [BACKGROUND ART]

In order to solve the depletion of fossil energy and global environmental problems caused by the use thereof, research into renewable and clean alternative energy sources such as solar energy, wind power, and water power has been actively conducted.

Of those, an interest in solar cells that can convert from solar light directly into electric energy has significantly increased. Here, the solar cell means a cell that absorbs light energy from solar light and generates a current-voltage by utilizing a photovoltaic effect from which electrons and holes are generated.

Currently, n-p diode-type silicon (Si) single crystal-based solar cells having photoenergy conversion efficiency of more than 20% may be manufactured and are actually used in the photovoltaic power generation, and there are also solar cells using a compound semiconductor, such as gallium arsenide (GaAS), which has better conversion efficiency than the n-p diode-type silicon (Si) single crystal-based solar cells. However, these inorganic semiconductor-based solar cells require materials which are purified to a very high purity for high efficiency and thus a lot of energy are consumed for the purification of original materials, and expensive process equipment is also needed in the process of producing single crystals using original materials or making films thinner, so that there is a limitation in lowering costs of manufacturing a solar cell, which has been an obstacle for the utilization of the solar cells on a large scale.

Therefore, the costs of a core material which is used for a solar cell, or a manufacturing process for a solar cell need to be greatly reduced in order to manufacture a solar cell at low costs, and studies have been actively conducted on a dye-sensitized solar cell and an organic solar cell, which may be manufactured using inexpensive materials and processes as an alternative to an inorganic semiconductor-based solar cell.

The dye-sensitized solar cell (DSSC) was initially developed by Michael Gratzel, a professor at the Swiss National Higher Institute of Technology in Lausanne (EPFL) in 1991 and was reported in Nature (Vol 353, P. 737).

An early dye-sensitized solar cell had a simple structure in which a dye absorbing light was absorbed on porous photo-anodes on a transparent electrode film through which light and electricity flow, another conductive glass substrate was positioned on the top, and a liquid electrolyte was filled therebetween. An operation principle of the dye-sensitized solar cell is as follows. When dye molecules chemically absorbed on surfaces of the porous photo-anodes absorb solar light, the dye molecules generate electron-hole pairs, and electrons are injected into a conduction band of semiconducting oxides used as the porous photo-anodes to be transported to the transparent conductive film, thereby generating current. The holes remaining in the dye molecules configure of complete solar cell circuits in a shape in which the holes are transported to photo-cathodes by hole conduction caused by oxidation-reduction reaction of a liquid or solid electrolyte or hole-conductive polymer, thereby performing external work.

In the configuration of the dye-sensitized solar cell, the transparent conductive film was mainly made of fluorine doped tin oxide (FTO) or indium doped tin oxide (ITO), and nanoparticles having a broad band gap are used as the porous photo-anodes. As the dye, various materials capable of absorbing light particularly well and easily separating an exciton generated by the light since a lowest unoccupied molecular orbital (LUMO) energy level of the dye is higher than an energy level of the conduction band of the photo-anode material to thereby increase the efficiency of the solar cell are chemically synthesized and used. The maximum efficiency of a liquid type dye-sensitized solar cell reported up to now has been only 11 to 12% for about 20 years. The liquid type dye-sensitized solar cell has relatively high efficiency to thereby make it possible to be commercialized. However, there are problems in stability according to time by a volatile liquid electrolyte and reducing cost due to using a high-cost ruthenium (Ru) based dye.

In order to solve these problems, research into uses of a non-volatile electrolyte using ionic solvent rather than the volatile liquid electrolyte, a gel-type polymer electrolyte, and an inexpensive pure organic dye has been conducted, but efficiency of a dye-sensitized solar cell using these materials is lower than that of the dye-sensitized solar cell using the volatile liquid electrolyte and ruthenium based dye.

Meanwhile, the organic photovoltaic (OPV) that has been studied in earnest since the mid-1990 is configured of organic materials having electron donor (D, or often called a hole acceptor) characteristics and electron acceptor (A) characteristics. When the solar cell made of organic molecules absorbs the light, electrons and holes are formed, which are called exciton. The exciton moves to a D-A interface, such that an electric charge is separated, an electron moves to the electric acceptor, and the hole moves to the electron donor, thereby generating photo current.

Since a distance at which the exciton generated in the electron donor may normally move is about 10 nm, which is significantly short, photo active organic materials may not be thickly laminated, such that optical absorption spectra was low and the efficiency was low. However, recently, due to introduction of so-called bulk heterojunction (BHJ) concept of increasing a surface area at an interface and development of an electron donor organic material having a small band gap to easily absorb solar light of a wide range, the efficiency was greatly increased, and organic solar cells with efficiencies exceeding 8% have been reported (Advanced Materials, 23 (2011) 4636).

In the organic solar cells, the manufacturing process of cells is simple due to easy processability of the organic material, diversity thereof, and a low cost thereof, such that the organic solar cells may be manufactured at a low unit cost, as compared to the existing solar cell. However, the organic solar cells have a problem that a structure of BHJ is degraded by moisture in air or oxygen to rapidly decrease the efficiency thereof, that is, a problem in the stability of the solar cell. When a technology of completely sealing the solar cell is introduced in order to solve this problem, the stability may be increased, but a cost may also be increased.

As a method of solving a problem of the dye-sensitized solar cell by the liquid electrolyte, an all-solid state dye-sensitized solar cell using Spiro-OMeTAD[2,2',7,7'-tetrkis(N,N-di-p-methoxyphenylamine)-9,9'-spirobifluorine], which is a solid-type hole conductive organic material instead of the liquid electrolyte to have efficiency of 0.74% was reported in Nature in 1998 by Michael Gratzel, a chemistry professor at EPFL in Switzerland, who is an inventor of the dye-sensitized solar cell. Afterward, the efficiency was increased up to about 6% by optimizing the structure, improving interfacial properties, and improving hole conductivity. In addition, a solar cell using the inexpensive pure organic dye instead of the ruthenium based dye and using P3HT, PEDOT, or the like as a hole conductor has been manufactured, but efficiency of the solar cell is still low at 2 to 7%.

Further, research into a solar cell using quantum dot nanoparticles as a light absorber instead of the dye and using hole conductive inorganic material or organic material instead of the liquid electrolyte has been reported. Many solar cells using CdSe, PbS or the like as the quantum dot and using conductive polymers such as spiro-OMeTAD or P3HT as the hole conductive organic material have been reported, but their efficiency is still very low at less than 5%. In addition, a solar cell using Sb₂S₃ as a light absorbing inorganic material and using PCPDTBT as the hole conductive inorganic material has been reported to have efficiency of about 6% (Nano Letters, 11 (2011) 4789). However further improvement in efficiency has not been reported.

In addition, the efficiency of about 9% has been reported using materials having organic/inorganic hybrid perovskite structure instead of dyes for the dye-sensitized solar cells, rather than quantum dots made of pure inorganic materials (Scientific Reports 2, 591). As a representative example of these compounds having a perovskite structure, CH₃NH₃Pbl₃ can be mentioned. The light absorption layer of CH₃NH₃Pbl₃ is formed by using CH₃NH₃I and Pbl₂ at a molar ratio of 1:1, and a hole transfer layer is formed on the light absorption layer formed from CH₃NH₃Pbl₃. However, since an unstable interface is formed between the light absorption layer of the substance having the perovskite structure and the hole transfer layer, the solar cell using the perovskite shows a relatively lower photoelectric voltage and fill factor as compared to other solar cells. Therefore, it is difficult to expect high efficiency for solar cells using perovskite.

### [DETAILED DESCRIPTION OF THE INVENTION]

### [Technical Problem]

It is an object of the present invention to provide a method for manufacturing a solar cell capable of inducing a spontaneous formation of a recombination preventing layer to produce a highly efficient perovskite solar cell

It is another object of the present invention to provide a solar cell manufactured by the method of manufacturing the solar cell.

### [DETAILED DESCRIPTION OF THE INVENTION]

### [Technical Problem]

Hereinafter, a method for manufacturing a solar cell according to a specific embodiment of the present invention, a solar cell manufactured by the method, and the like will be described.

According to one embodiment of the present invention, there is provided a method for manufacturing a solar cell comprising the steps of: spin-coating a solution containing an organic halide and a metal halide in a molar ratio of 1.03: 1 to 1.07: 1 on an electron transport layer and then subjecting to heat-treatment to form a light absorption layer including an organic/inorganic hybrid perovskite compound and a recombination preventing layer formed from an organic halide on the light absorption layer.

As used herein, the term "perovskite" is named after the Russian mineralogist, Lev Perovski, and refers to any material having a formula of AMX₃ consisting of cations (A and M) and an anion (X), and having the same type of structure as calcium titanium oxide (CaTiO₃), the first perovskite type material, which was discovered in the Ural mountains. In the case of the perovskite used in the technical field to which the present invention pertains, a monovalent methyl ammonium ion is usually used as a cation corresponding to A, and thus the term "organic/inorganic hybrid" is used.

Typically, CH₃NH₃Pbl₃ is known as an organic/inorganic hybrid perovskite compound. However, when CH₃NH₃Pbl₃ is applied to solar cells, there was a limitation in improving the efficiency of solar cells, and research to develop new perovskite materials has been conducted. As an example of such a technique, a technology to improve the efficiency of solar cells was introduced by substituting iodine(I) of CH₃NH₃Pbl₃ with bromine(Br) or chlorine(CI), or substituting a methylammonium cation(CH₃NH₃) with a formamideinium cation (HC(NH₂)₂),

On the other hand, conventional perovskite-based solar cell exhibited a relatively lower photoelectric voltage and fill factor as compared to other solar cells due to an unstable interface between the light absorption layer of the substance having the perovskite structure and the hole transfer layer. Therefore, there was a limitation in improving the efficiency of the solar cell.

Thus, the present inventors have conducted continuous research on perovskite-based solar cells, and as a result, found that, even if a known perovskite material is used, a highly efficient solar cell can be provided reproducibly if it is induced so that a recombination preventing layer is formed spontaneously by using the organic halide and the metal halide at a specific molar ratio, thereby completing the present invention.

Hereinafter, a method for manufacturing a solar cell according to one embodiment will be described in detail.

The method for manufacturing a solar cell according to the embodiment essentially includes the step 2) of the following steps, and may optionally further include at least one of the remaining steps.
1) forming an electron transport layer on a first electrode comprising a conductive transparent substrate;
2) spin-coating a solution containing an organic halide and a metal halide in a molar ratio of 1.03: 1 to 1.07: 1 onto an electron transport layer and then subjecting to heat treatment to form a light absorption layer including an organic/inorganic hybrid perovskite compound and a recombination preventing layer formed from the organic halide on the light absorption layer,
3) forming a hole transport layer on the recombination preventing layer; and
4) forming a second electrode on the hole transport layer.

The first electrode used in the manufacturing method of one embodiment can be expressed as a working electrode or a semiconductor electrode, and the second electrode can be expressed as a counter electrode.

As the first electrode and the second electrode, various electrodes known in the technical field to which the present invention pertains can be used without limitation. As a non-limiting example, the conductive transparent substrate included in the first electrode may be a glass substrate or a plastic substrate containing indium tin oxide (ITO), fluorine tin oxide (FTO), ZnO-Ga₂O₃, ZnO-Al₂O₃, tin-based oxide, zinc oxide, or a mixture thereof. At this time, as the plastic substrate, there may be mentioned those formed of polyethylene terephthalate, polyethylene naphthalate, polycarbonate, polypropylene, polyimide or triacetylcellulose. On the other hand, as a non-limiting example, the second electrode may be a conductive layer containing at least one material selected from the group consisting of Pt, Au, Ni, Cu, Ag, In, Ru, Pd, Rh, Ir, Os, C and a conductive polymer.

In the step 1), an electron transport layer may be formed on the first electrode according to a method known in the technical field to which the present invention belongs. As a non-limiting example, a metal oxide paste in which a metal oxide and a pore-forming polymer are mixed is coated on a first electrode and sintered at a high temperature to form a porous metal oxide layer as an electron transport layer. In this case, examples of usable metal oxides include TiO₂, SnO₂, ZnO, Nb₂O₅, Ta₂O₅, WO₃, W₂O₅, In₂O₃, Ga₂O₃, Nd₂O₃, PbO, CdO, or the like. Examples of the pore-forming polymer include ethylcellulose, hydroxypropyl cellulose, polyethylene glycol, polyethylene oxide, polyvinyl alcohol, polyvinylpyrrolidone or a mixture thereof.

The porous metal oxide layer is not particularly limited, but it may have a mesoporous structure having an average pore size of about 20 nm to 500 nm. In order to form such a mesoporous structure, a metal oxide paste may be coated on the first electrode and then sintered at about 100°C to 700°C.

In the manufacturing method of this embodiment, a hole blocking layer may be formed on the first electrode before forming the electron transport layer, if necessary. The hole blocking layer may be formed on the first electrode in accordance with a method known in the technical field to which the present invention pertains. As a non-limiting example, a precursor solution of a metal oxide may be coated on the first electrode and then sintered at a high temperature to form a hole blocking layer. As such a hole blocking layer, a dense TiO₂ layer (compact TiO₂ layer) is known.

In the step 2), the organic halide and the metal halide may be used at a specific molar ratio to simultaneously form the light absorption layer and a recombination layer on the electron transport layer.

First, in the step 2), an organic halide and a metal halide are mixed in a molar ratio of 1.03: 1 to 1.07: 1. If the content of the organic halide is less than the above range, the photoelectric conversion efficiency cannot be improved due to the unstable interface between the light absorption layer and the hole transport layer. Further, if the content of the organic halide exceeds the above range, the photocurrent density, the photoelectric voltage and the fill factor (FF) are rather lowered which results in a reduction in the photoelectric conversion efficiency.

More specifically, the molar ratio between the organic halide and the metal halide may be adjusted to 1.04: 1 to 1.06: 1, 1.05: 1 to 1.06: 1, or about 1.06: 1. In such a case, a very excellent photoelectric voltage and FF, and a photoelectric conversion efficiency of 19.5% or more can be achieved. In particular, when the molar ratio between the organic halide and the metal halide is adjusted to 1.05: 1 to 1.06: 1 or about 1.06: 1, a very excellent photoelectric voltage and FF and a photoelectric conversion efficiency of 20% or more can be achieved.

As the organic halide and the metal halide, various compounds capable of obtaining the organic/inorganic hybrid perovskite compound can be used without limitation. As an example, as the organic halide, a compound represented by the following Chemical Formula 1 can be used.

[Chemical Formula 1] AX

in Chemical Formula 1, A is an organic cation of R₁R₂R₃R₄N⁺ or (R₅R₆N=CH-NR₇R₈)⁺,
wherein R₁ to R₈ are each independently hydrogen or a C₁₋₁₀ alkyl, provided that at least one of R₁ to R₄ is a C₁₋₁₀ alkyl, and X is halogen.

Specifically, in Formula 1, A may be CH₃NH₃⁺ or formamidinium (HC(NH₂)₂) cation.

On the other hand, as the metal halide, a compound represented by the following Chemical Formula 2 may be used.

[Chemical Formula 2] MX₂

in Chemical Formula 2, M is a divalent metal cation and X is the same or different halogen.

The divalent metal cation may be Pb²⁺, Sn²⁺, Pd²⁺, Cu²⁺, Ge²⁺, Sr²⁺, Cd²⁺, Ca²⁺, Ni²⁺, Mn²⁺, Fe²⁺, Co²⁺, Sn²⁺, Yb²⁺ or Eu²⁺.

In Formulas 1 and 2, the halogen may be Cl⁻, Br⁻, or I⁻.

In particular, according to the manufacturing method of one embodiment, even if the light absorption layer of CH₃NH₃Pbl₃ is produced by using CH₃NH₃I as the organic halide and using Pbl₂ as the metal halide, a photoelectric conversion efficiency of 19.5% or more can be exhibited due to the recombination preventing layer which is spontaneously formed according to the specific use molar ratio of the organic halide and the metal halide.

The organic halides and the metal halides may be mixed under an organic solvent. At this time, various organic solvents known in the technical field to which the present invention pertains can be used as the organic solvent. For example, N,N-dimethylformamide (DMF), N,N-dimethylsulfoxide (DMSO) or a mixture thereof may be used as the organic solvent. In the precursor solution thus obtained, the organic halide and the metal halide may be dissociated and dispersed in the state of cation and anion.

In the step 2), the precursor solution obtained above is spin-coated on the electron transport layer. The spin-coating condition is not particularly limited, but the spin-coating may be performed at a speed of about 100 to 30,000 rpm, about 100 to 20,000 rpm, about 100 to 10,000 rpm, about 1,000 to 5,000 rpm, or about 2,000 to 5,000 rpm for 5 seconds to 2 minutes.

In the step of spin-coating the precursor solution, the organic solvent may be dropped onto the precursor solution during spin-coating. Through this process, an adduct can be formed. As the organic solvent, it is appropriate to use a solvent that can wash the solvent used in the precursor solution, for example, dimethylformamide. As one example, an ether solvent such as ethyl ether may be used.

As described above, the precursor solution can be subjected to heat treatment while spin-coating on the electron transport layer or after spin-coating on the electron transport layer. Specifically, the precursor solution may be heat-treated at a temperature of about 40 to 150°C simultaneously with or after spin-coating. At this time, the heat treatment temperature can be kept constant or changed. As one example, the heat treatment temperature may be adjusted to about 40 to 90°C and then again to about 80 to 150°C. In this temperature range, a good light absorption layer can be formed from the organic halide and the metal halide, and at the same time, the unreacted organic halide can form a molecular film (recombination preventing layer) on the light absorption layer. The molecular film thus formed can solve the problem caused by the unstable interface between the light absorption layer and the hole transport layer.

The heat treatment time is not particularly limited, but it can be adjusted to about 30 seconds to 30 minutes when the heat treatment is performed in the temperature range described above.

According to the step 2), a light absorption layer composed of an organic hybrid perovskite compound is formed on the electron transport layer, and at the same time, a recombination preventing layer having a very thin thickness and formed from an organic halide can be formed. The thickness of the recombination preventing layer may be several Å.

In the step 3), a hole transport layer may be formed on the recombination preventing layer. The hole transport layer may be formed through various methods known in the technical field to which the present invention belongs. As a non-limiting example, the hole transport layer may be formed by coating a solid-type hole transport material on the recombination preventing layer. Specifically, examples of the solid-type hole transport material may include spiro-OMeTAD(2,2',7,7'-tetrakis-(N,N-di-p-methoxyphenylamine)9,9'-spirobifluorene)), P3HT(poly (3-hexylthiophene)), PCPDTBT(poly[2,1,3-benzothiadiazole-4,7-diyl[4,4-bis (2-ethylhexyl)-4H-cyclopenta[2,1-b;3,4-b']dithiophen-2,6-diyl]]), PVK(poly(N-vinylcarbazole)), HTM-TFSI (1-hexyl-3-methylimidazolium bis(trifluoromethylsulfonyl)imide), Li-TFSI (lithium bis(trifluoromethanesulfonyl)imide), tBP (tert-butylpyridine), PDOT:PSS (poly(3,4-ethylenedioxythiophene)poly(styrenesulfonate) or a mixture thereof.

Subsequently, in the step 4), a second electrode may be formed on the hole transport layer through various methods known in the technical field to which the present invention belongs, thereby manufacturing the solar cell. The types of the second electrode that can be used include those described above.

In addition to the steps described above, the manufacturing method of one embodiment may further include steps that are conventionally employed in the technical field to which the present invention belongs. As a non-limiting example, when a solar cell including an electrolyte layer is used, a step of injecting an electrolyte solution between the first electrode and the second electrode to form an electrolyte layer may be further included.

The solar cell manufactured according to the above-described manufacturing method can exhibit a high photoelectric voltage and FF, and thus can exhibit a high photoelectric conversion efficiency reproducibly.

On the other hand, according to another embodiment of the present invention, there is provided a solar cell manufactured by the above manufacturing method. Specifically, the above-described solar cell includes a first electrode including a conductive transparent substrate; an electron transport layer formed on the first electrode; a light absorption layer formed on the electron transport layer and including an organic/inorganic hybrid perovskite compound; a recombination preventing layer formed on the light absorption layer and formed from an organic halide; a hole transfer layer formed on the recombination preventing layer; and a second electrode formed on the hole transport layer.

The solar cell comprises a recombination preventing layer which is spontaneously formed from an organic halide by adjusting a molar ratio of an organic halide and a metal halide to produce a hybrid organic perovskite compound to a specific range, and thereby, high photoelectric conversion efficiency can be exhibited even if a conventional organic/inorganic perovskite material is used. In particular, in the case where the structure of the solar cell according to another embodiment of the present invention is employed, even if CH₃NH₃Pbl₃, which is known as a typical example of the organic/inorganic hybrid perovskite compound, is used, it exhibits excellent photoelectric voltage and FF, thereby providing a solar cell capable of exhibiting a photoelectric conversion efficiency of 19.5% or more.

### [ADVANTAGEOUS EFFECTS]

According to one embodiment of the present invention, a highly efficient perovskite solar cell can be manufactured by inducing a spontaneous formation of a recombination preventing layer using the organic halide and the metal halide at a specific molar ratio.

### [BRIEF DESCRIPTION OF DRAWINGS]

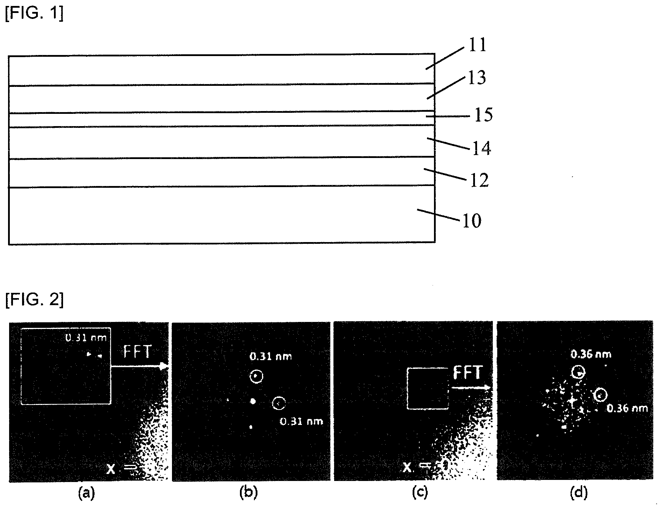

FIG. 1 shows the fabrication process and cleavage map of the pPs619C1310-CpPCT540 vector.

### [DETAILED DESCRIPTION OF THE EMBODIMENTS]

FIG. 1 is a cross-sectional view schematically showing the structure of a solar cell according to an embodiment of the invention.

FIGS. 2(a) and 2(b) are STEM images of the layer surface obtained by coating a DMF solution and heat-treating it according to Comparative Example 1, and FIGS. 2(c) and 2(d) are a STEM image of the layer surface obtained by coating a DMF solution and heat-treating it according to Example 2.

### [DETAILED DESCRIPTION OF THE EMBODIMENTS]

Hereinafter, the function and effects of the invention will be described in more detail through concrete examples. However, these examples are for illustrative purposes only, and are not intended to limit the present invention thereto in any way.

### Example 1: Preparation of solar cell (molar ratio of CH₃NH₃I and Pbl₂ = 1.04:1)

The FTO substrate having a size of 25 mm x 25 mm was etched on its end portions to partially remove FTO. 0.15 M solution of [(CH₃)₂CHO]₂Ti(C₅H₇O₂)₂(titanium diisopropoxide bis(acetylacetonate)) 1-butanol was coated onto the FTO substrate in the thickness of 40 nm at 2800 rpm for 20 seconds, and then sintered at 125°C for 5 minutes to prepare a dense TiO₂ dense film on the FTO substrate.

On the other hand, a TiO₂ powder having an average particle size of 50 nm, terpineol, ethyl cellulose and lauric acid were mixed at a weight ratio of 1.25:6:0.9:0.1 to prepare a TiO₂ paste, and the prepared TiO₂ paste was added to 10 mL of ethanol.

Then, a TiO₂ paste diluted with ethanol was spin-coated onto the dense TiO₂ layer and sintered at 550°C for 1 hour. Then, the sintered substrate was immersed in an aqueous solution of 20 mM TiCl₄ at 90°C for 10 minutes, washed with deionized water, and then sintered at 500°C for 15 minutes to form a porous TiO₂ layer.

On the other hand, CH₃NH₃I (methylammonium iodide), Pbl₂ (lead(II) iodide) and DMSO (dimthyl sulfoxide) were added at a molar ratio of 1.04:1:1 to DMF (N,N-dimethyl formamide) and dissolved. Then, the mixture was stirred at room temperature for about 1 hour to prepare 52 wt% of DMF solution.

Then, the DMF solution was coated onto the porous TiO₂ layer at 4,000 rpm for 30 seconds.

At this time, diethyl ether was dropped onto the coating film of the DMF solution 10 seconds after the start of coating. Subsequently, the obtained coating film was heat-treated at 65°C for 1 minute and at 100°C for 2 minutes to simultaneously form a light absorption layer and a recombination preventing layer.

A chlorobenzene solution in which spiro-OMeTAD (2,2',7,7'-tetrakis(N,N-di(4-methoxyphenyl)amino)-9,9'-spirobifluorene) was dissolved was spin-coated onto the recombination preventing layer at 3000 rpm for 30 seconds to form a hole transport layer. Ag was vacuum-deposited thereto with a thermal evaporator to form an electrode.

### Example 2: Preparation of solar cell (molar ratio of CH₃NH₃I and Pbl₂ = 1.06:1)

A solar cell was prepared in the same manner as in Example 1, except that CH₃NH₃I and Pbl₂ were used in a molar ratio of 1.06: 1 in Example 1.

### Comparative Example 1: Preparation of solar cell (molar ratio of CH₃NH₃I and Pbl₂ = 1:1)

A solar cell was prepared in the same manner as in Example 1, except that CH₃NH₃I and Pbl₂ were used in a molar ratio of 1: 1 in Example 1.

### Comparative Example 2: Preparation of solar cell (molar ratio of CH₃NH₃I and Pbl₂ = 1.02:1)

A solar cell was prepared in the same manner as in Example 1, except that CH₃NH₃I and Pbl₂ were used in a molar ratio of 1.02: 1 in Example 1.

### Comparative Example 3: Preparation of solar cell (molar ratio of CH₃NH₃I and Pbl₂ = 1.08:1)

A solar cell was prepared in the same manner as in Example 1, except that CH₃NH₃I and Pbl₂ were used in a molar ratio of 1.08: 1 in Example 1.

### Comparative Example 4: Preparation of solar cell (molar ratio of CH₃NH₃I and Pbl₂ = 1.1:1)

A solar cell was prepared in the same manner as in Example 1, except that CH₃NH₃I and Pbl₂ were used in a molar ratio of 1.1: 1 in Example 1.

### Test Example 1: Performance evaluation of solar cell

The photocurrent density (J_{sc}), the photoelectric voltage (V_{oc}), the fill factor (FF) and the power conversion efficiency (PCE) of the solar cell were measured. The results are shown in Table 1 below.

**[Table 1]**

| | CH₃NH₃I:PbI₂ [molar ratio] | J_{sc} [mA/cm²] | V_{oc} [V] | FF | PCE [%] |
|---|---|---|---|---|---|
| Example 1 | 1.04:1 | 23.76 | 1.070 | 0.780 | 19.83 |
| Example 2 | 1.06:1 | 23.62 | 1.127 | 0.777 | 20.70 |
| Comparative Example 1 | 1.00:1 | 23.80 | 1.065 | 0.723 | 18.32 |
| Comparative Example 2 | 1.02:1 | 23.63 | 1.064 | 0.752 | 18.91 |
| Com parative Example 3 | 1.08:1 | 23.22 | 1.095 | 0.749 | 19.05 |
| Comparative Example 4 | 1.10:1 | 21.86 | 1.120 | 0.635 | 15.55 |

### Test Example 2: Confirmation of formation of recombination preventing layer

The DMF solution was coated and heat-treated in accordance with Example 2 and Comparative Example 1, and the surface of the resulting layer was observed by STEM (Scanning Transmission Electron Microscope) to confirm the formation of the recombination preventing layer. STEM images of the layer surface obtained by coating the DMF solution and subjecting to heat treatment according to Comparative Example 1 are shown in FIGS. 2(a) and 2(b). STEM images of the layer surface obtained by coating the DMF solution and subjecting to heat treatment according to Example 2 are shown in FIGS. 2(c) and 2(d).

In the layer surface obtained by coating the DMF solution and subjecting to heat treatment according to Comparative Example 1, CH₃NH₃Pbl₃ lattice fringes of 0.31 nm could be confirmed. In contrast, in the layer surface obtained by coating the DMF solution and subjecting to heat treatment according to Example 2, CH₃NH₃I lattice fringes of 0.36 nm could be confirmed. Thus, it was confirmed that the recombination preventing layer formed from the organic halide was formed on the light absorption layer prepared according to one embodiment of the present invention.

### [Explanation of sign]

10: First electrode
11: Second electrode
12: Electron transfer layer
13: Hole transport layer
14: Light absorption layer
15: Recombination preventing layer

## Claims

1. A method for manufacturing a solar cell comprising the steps of: spin-coating a solution containing an organic halide and a metal halide in a molar ratio of 1.03: 1 to 1.07: 1 on an electron transport layer and then subjecting to heat-treatment to form a light absorption layer including an organic/inorganic hybrid perovskite compound, and a recombination preventing layer formed from an organic halide on the light absorption layer.

2. The method for manufacturing a solar cell according to claim 1,
wherein a compound represented by the following Chemical Formula 1 is used as the organic halide:
[Chemical Formula 1] AX
in Chemical Formula 1,
A is an organic cation of R₁R₂R₃R₄N⁺, or (R₅R₆N=CH-NR₇R₈)⁺,
wherein R₁ to R₈ are each independently hydrogen, or a C₁₋₁₀ alkyl, provided that at least one of R₁ to R₄ is a C₁₋₁₀ alkyl, and X is halogen.

3. The method for manufacturing a solar cell according to claim 1,
wherein a compound represented by the following Chemical Formula 2 is used as the metal halide:
[Chemical Formula 2] MX₂
in Chemical Formula 2,
M is a divalent metal cation, and X is the same or different halogen.

4. The method for manufacturing a solar cell according to claim 1,
wherein the solution further includes dimethylformamide, dimethylsulfoxide or a mixture thereof as the solvent.

5. The method for manufacturing a solar cell according to claim 1,
wherein the solution is spin-coated and then heat-treated at 40°C to 150°C.

6. The method for manufacturing a solar cell according to claim 1,
further comprising any one or more of the steps of: forming an electron transport layer on a first electrode comprising a conductive transparent substrate; forming a hole transport layer on the recombination preventing layer; and forming a second electrode on the hole transport layer.

7. A solar cell comprising:
a first electrode including a conductive transparent substrate;
an electron transport layer formed on the first electrode;
a light absorption layer formed on the electron transport layer and including an organic/inorganic hybrid perovskite compound;
a recombination preventing layer formed on the light absorption layer and formed from an organic halide;
a hole transfer layer formed on the recombination preventing layer; and
a second electrode formed on the hole transport layer.
